# EUROPEAN PATENT SPECIFICATION

(11) **EP 1 952 935 B1**
(45) Date of publication and mention of the grant of the patent: **11.05.2016**
(21) Application number: 07101602.6
(22) Date of filing: 01.02.2007
(51) Int. Cl.: B23K 35/26, B23K 35/02, H01L 23/00, H05K 3/34

(54) **Solder paste composition and solder precoating method**
Lötpastenzusammensetzung und Lötvorbeschichtungsverfahren
Composition de pâte à souder et procédé de revêtement préliminaire de soudure

(43) Date of publication of application: 06.08.2008
(73) Proprietor: HARIMA CHEMICALS, INC., Kakogawa-shi, Hyogo 675-0019 (JP)
(72) Inventor: Sakurai, Hitoshi, Kakogawa-shi Hyogo 675-0019 (JP); Kukimoto, Yoichi, Kakogawa-shi Hyogo 675-0019 (JP)
(74) Representative: Smaggasgale, Gillian Helen

(56) References cited:
- EP-A1- 1 038 628
- EP-A1- 1 342 726
- WO-A-01/72466
- JP-A- 7 326 853
- US-A- 5 162 257
- US-A1- 2004 217 152

## Description

### 1. Field of the Invention

The present invention relates to a solder paste composition suitable, when mounting electronic components on an electronic circuit substrate, for precoating the substrate with solder by using a dam. The present invention also relates to a solder precoating method using the solder paste composition.

### 2. Description of Related Art

Recently, as the miniaturization and the lightening of electronic equipments have increased, electronic components to be mounted require a large number of pins and a fine pitch. The conductor pattern also increases the tendency for a fine pitch where a large number of conductors are formed at extremely small spaced intervals in a narrow range. Therefore, when the electronic components are connected to an electronic circuit substrate, a mounting method using solder bumps is widely employed instead of conventional wire bonding.

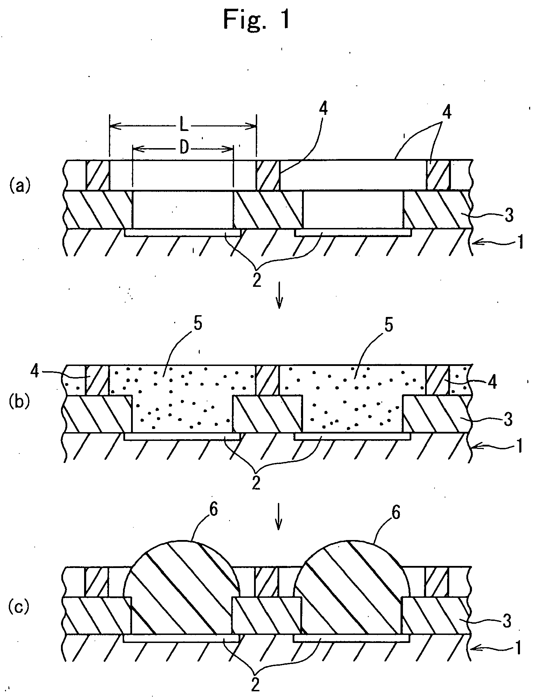

As a method of forming the solder bumps, a solder precoating method using a resin mask (a dam) has been employed (Japanese Unexamined Patent Publication No. 2002-334895). Figs. 1(a) to 1(c) are process drawings showing the method for forming the solder bumps by means of a solder precoating method using a general dam, as described in Japanese Unexamined Patent Publication No. 2002-334895.

In this bump forming method, on a substrate 1 coated with a solder resist film 3 provided with opening parts for preventing electrodes 2 formed on the surface of the substrate 1 from being covered, a dam 4 is firstly formed so as to surround the electrodes 2, as shown in Fig. 1(a).

Subsequently, as shown in Fig. 1(b), a solder paste composition 5 containing predetermined solder powder is filled over the electrodes 2 within the opening parts surrounded by the dam 4. This is then heated to have the solder adhere to the surfaces of the electrodes 2, thereby forming solder bumps 6, as shown in Fig. 1 (c).

In accordance with the solder precoating method using the above mentioned dam 4, the solder bumps 6 can be formed with a fine pitch.

However, during the time of heat-melting, the solder powder within the solder paste composition 5 filled within the opening parts surrounded by the dam 4 cannot be deposited satisfactorily on the electrodes 2. This results in the problem that no solder bumps 6 can be formed on the electrodes 2, this being called a "bump defect". Only one bump defect on a substrate would ruin the substrate. Hence, there has been a strong desire for the development of a solder paste composition capable of forming the bumps 6 with a high yield.

There has also been a tendency for non-uniformity in the height of the solder bumps 6 formed. It is preferable to form the solder bumps 6 so as to have a uniform height because the uniformity in the height of the solder bumps 6 exerts a great influence on the reliability of junctions when mounting the components in the succeeding step.

Compared with the conventional manner using no dam, in the solder precoating method using the dam, the opening parts above the electrodes become thick by the amount of the dam thickness (In general, the thickness of the dam 4 is several times to several tens of times the thickness of the solder resist film 3). Consequently, with the method using the dam, the solder powder cannot be deposited satisfactorily on the electrodes 2. This creates the above mentioned problems not encountered in the conventional manner.

Japanese Unexamined Patent Publication No. 2002-141367 describes a way of forming bumps in a solder precoating method using a mask (a dam), wherein a solder paste contains solder powder, and 10 weight % or below of the solder powder has a particle size of not less than the thickness of the mask (the dam) nor more than 1.5 times the thickness thereof.

This publication No. 2002-141367 describes that, even if a squeegee is repeatedly shifted on the mask in order to ensure the filling of the solder paste into opening parts, the solder powder already filled in the opening parts is less likely to be removed, and the bumps are unsusceptible to variations in dimension. However, this method is not necessarily sufficient to suppress the variations in the bumps. This publication is also silent about the bump defect due to unsatisfactory deposition of the solder powder on the electrodes during the time of heat-melting.

WO 01/72466 discloses solder and a method of manufacturing the solder wherein powdered free silver is added to a solder alloy with a particle size sufficient to preserve silver metallization during use and with a concentration sufficient to maximize the effectiveness and avoid adverse effects on solder reflow characteristics.

### SUMMARY OF THE INVENTION

An advantage of the present invention is the ability to provide a solder paste composition with which the occurrence of bump defects can be suppressed, and solder bumps of a uniform height can be formed with a high yield by a solder precoating method using a dam, as well as a solder precoating method using the solder paste composition.

The present inventors have made tremendous research effort to solve the above mentioned problems, and they have completed the present invention based on the following new finding. That is, in a solder paste composition for use in a solder occurrence of bump defects. This enables the yield to be improved and the bumps formed to have a uniform height.

Specifically, the solder paste composition of the present invention can be comprised of the following constitutions.
(1) A solder paste composition for use in a solder precoating method of forming solder bumps by forming a dam around electrodes on a substrate, wherein the solder paste composition contains solder powder which is of a particle size distribution in which particles having a particle size of below 10 µm are present 16% or more, and the sum of the particles having a particle size of below 10 µm and particles having a particle size of 10 µm or more and below 20 µm is 90% or more, the solder paste composition being of a deposition type.
(2) The solder paste composition as set forth in item (1), wherein the solder powder is of a particle size distribution in which particles having a particle size of below 10 µm are present 20% or more.
(3) The solder paste composition as set forth in item (1) or (2), wherein the solder powder is of a particle size distribution in which the sum of particles having a particle size of below 10 µm and particles having a particle size of 10 µm or more and below 20 µm is 95% or more.
(4) The solder paste composition as set forth in items (1)-(3), containing tin powder and a salt of a metal selected from lead, copper and silver.
(5) The solder paste composition as set forth in items (1)-(3), containing tin powder and a complex of at least one ion selected from silver ions and copper ions and at least one compound selected from aryl phosphines, alkyl phosphines, and azoles.
(6) The solder paste composition as set forth in the item (4) or (5), wherein the ratio of the mass of the tin powder to the mass of the metal salt or the complex is from 99:1 to 50:50.
(7) A solder precoating method of forming solder bumps by forming a dam around electrodes on a substrate, introducing a solder paste composition over the electrodes within openings surrounded by the dam, and heating the solder paste composition introduced, so that solder adheres to surfaces of the electrodes. The solder precoating method uses a solder paste composition containing solder powder which is of a particle size distribution in which particles having a particle size of below 10 µm are present 16% or more, and the sum of the particles having a particle size of below 10 µm and particles having a particle size of 10 µm or more and below 20 µm is 90% or more, the solder paste being of a deposition type.
(8) The solder precoating method as set forth in item (7), wherein the solder powder is of a particle size distribution in which particles having a particle size of below 10 µm are present 20% or more.
(9) The solder precoating method as set forth in item (7) or (8), wherein the solder powder is of a particle size distribution in which the sum of particles having a particle size of below 10 µm and particles having a particle size of 10 µm or more and below 20 µm is 95% or more.
(10) The solder precoating method as set forth in items (7) to (9), wherein the solder paste composition contains tin powder and a salt of a metal selected from lead, copper and silver.
(11) The solder precoating method as set forth in items (7) to (9), wherein the solder paste composition contains tin powder and a complex of at least one ion selected from silver ions and copper ions and at least one compound selected from aryl phosphines, alkyl phosphines, and azoles.
(12) The solder precoating method as set forth in item (10) or (11), wherein the ratio of the mass of the tin powder to the mass of the metal salt or the complex is from 99:1 to 50:50.

In the present invention, all particle size distributions are on a "by number" basis.

In the present invention, the term "mass" used for various ratios may be transposed to the term "weight". Even if the term "mass" is transposed to the term "weight", there is no change in the range of the ratio.

In accordance with the present invention, in the solder paste composition for use in a solder precoating method using a dam, the solder powder contained in the solder paste composition has a predetermined particle size distribution. Hence, the solder powder in the solder paste composition introduced in the openings surrounded by the dam can be reliably deposited on the electrodes during the time of heat-melting, thereby suppressing the occurrence of bump defects. This produces the effect of improving the yield and providing the solder bumps of a uniform height. Additionally, by setting the particle size distribution of the solder powder contained in the solder paste composition to the more specific range, the occurrence of bump defects can be suppressed more effectively, and solder bumps of a more uniform height can be provided. Additionally, by choosing a deposition type of solder paste composition as the above mentioned solder paste composition, solder bumps can be formed accurately with a fine pitch on the electrodes, and the occurrence of voids can also be suppressed.

Other objects and advantages of the present invention will become more apparent from the following detailed description of the present invention when taken in conjunction with the accompanying drawings.

### BRIEF DESCRIPTION OF THE DRAWINGS

Figs. 1(a) to 1(c) are process drawings showing a method of forming solder bumps by a solder precoating method using a dam.

### DESCRIPTION OF PREFERRED EMBODIMENTS

A preferred embodiment of a solder paste composition and a solder precoating method using the solder paste composition according to the present invention will be described below in detail with reference to the accompanying drawings. Fig. 1 shows a method of forming solder bumps using the solder paste composition in this preferred embodiment. In this method of forming the solder bumps, on a substrate 1 coated with a solder resist film 3 provided with opening parts for preventing electrodes 2 formed on the surface of the substrate 1 from being covered, a dam 4 is firstly formed so as to surround the electrodes 2, as shown in Fig. 1(a).

Subseqtiently, as shown in Fig. 1(b), a solder paste composition 5 is filled over the electrodes 2 within the opening parts surrounded by the dam 4. The filled solder paste composition 5 is then heated so that the solder can be adhered to the surfaces of the electrodes 2, thereby forming solder bumps 6, as shown in Fig. 1(c) (a solder precoating method).

A plurality of the electrodes 2 is disposed with a predetermined pitch on the surface of the substrate 1. As the solder resist film 3, epoxy resin, acryl resin, polyimide resin and the like can be used, and epoxy resin is preferred.

The dam 4 can be formed with, for example, a film-shaped photoresist, a dry film resist, or a liquid photoresist. When using the film-shaped photoresist, it may be press-adhered to the surface of the substrate 1. When using the liquid photoresist, the dam 4 can be formed by applying the liquid resin to the surface of the substrate 1 by using coating means such as a spin coater, allowing the liquid resin to be cured, and performing exposure process and development (etching) process through a predetermined photomask (not shown). Examples of etchant are Na₂CO₃ aqueous solution, Cu₂Cl₂ aqueous solution, CuCl₂ aqueous solution, and FeCl₃ aqueous solution.

The dam 4 may be formed so as to surround the electrodes 2, and have such a wall-shape as to partition the electrodes 2 from each other.

The internal diameter of the dam 4 (the length of a side when it is a tetragon) L is about 1 to 3 times, preferably 1.2 to 2 times to a diameter D of the exposed electrodes 2. No special limitations are imposed on the thickness of the dam 4 (namely the thickness of the resist resin film), and it may be higher or lower than the height of the solder bumps 6 formed. Specifically, the height of the solder bumps 6 is 0.05 to 3 times, preferably 0.1 to 1.5 times to a total thickness of the thickness of the dam 4 and the thickness of the solder resist film 3. The thickness of the dam 4 is usually about 10 to 300 µm, preferably about 30 to 150 µm.

The dam 4 may be removed after forming the solder bumps 6, or may remain as it is. However, when the height of the dam 4 is close to or over the height of the solder bumps 6, it is preferable to remove the dam 4 because it might constitute an obstruction to a solder joint. The dam 4 can be removed with, for example, alkaline treatment using an aqueous alkali solution such as sodium hydroxide or potassium hydroxide, or an organic amine aqueous solution such as 2-ethanol amine solution, or an organic solvent solution.

On the other hand, from the viewpoint of simplifying the process, it is preferable that the dam 4 not be removed. In accordance with the present invention, the step of removing the dam 4 is not necessarily required because the solder height can be sufficiently high by adjusting the dam height of the resist and the amount of metal in the maternal.

Here, the solder paste composition 5 contains solder powder, which is of a particle size distribution in which particles having a particle size of below 10 µm are present 16% or more, preferably 20% or more, and the sum of the particles having a particle size of below 10 µm and particles having a particle size of 10 µm or more and below 20 µm is 90% or more, preferably 95% or more. Thus, the solder powder in the solder paste composition 5 filled in the opening parts surrounded by the dam 4 shown in Fig. 1(b) can surely be deposited on the electrodes 2 during the time of heat-melting, thereby suppressing the occurrence of bump defects. This enables the yield to be improved and the formed bumps to have a uniform height. In contrast, when the particle size distribution of the above mentioned solder powder is not the above predetermine particle size distribution, there may arise bump defects and variations in the height of the formed solder bumps 6.

In the present invention, the term "bump defects" means there are regions on the electrodes 2 where no solder bump 6 is formed. For example, the presence or absence of a solder bump defect region and the number of occurrence of defects can be determined on a microscope ("VHX-200" manufactured by KEYENCE CORPORATION), as described later.

The particle size distribution in the present invention is a value determined by measuring it by a microtrack method. The term "microtrack method" means a method of measuring a particle size distribution, which uses the diffraction scattering with laser, and can measure it with a high resolution in a wide measuring range.

No special limitations are imposed on the composition of the solder powder. For example, there are solder alloy powders of Sn (tin)-Pb (lead) base, Sn-Ag (silver) base, or Sn-Cu (copper) base, and no-lead alloy powders of Sn-Ag-In (indium) base, Sn-Ag-Bi (bismuth) base, or Sn-Ag-Cu base. These solder powders may be used singly or in combination of two or more kinds. For example, Sn-Ag-In base and Sn-Ag-Bi base may be blended together to obtain Sn-Ag-In-Bi base solder alloy powder, or the like.

No special limitations are imposed on the above mentioned solder paste composition 5, except that it contains solder powder having a predetermined particle size distribution. In the present invention, a deposition type solder composition is used.

By using the deposition type solder composition as the solder paste composition 5, the solder bumps 6 can be formed accurately on the electrodes 2 with a fine pitch, and the occurrence of voids can be suppressed.

The deposition type solder composition contains, for example, tin powder and an organic acid lead salt as the solder powder. When this composition is heated, the lead atoms of the organic acid lead salt can be replaced with tin atoms and liberated, and they can be diffused in excessive tin metallic powder, thereby forming a Sn-Pb alloy.

As this deposition type solder composition, there are, for example, (i) a deposition type solder composition containing tin powder and the salt of metal selected from lead, copper, silver and the like; and (ii) a deposition type solder composition containing tin powder and a complex of at least one selected from silver ion and copper ion and at least one selected from aryl phosphines, alkyl phosphines, and azoles. In the above mentioned deposition type composition, the metal salt of the composition (i) and the complex of the composition (ii) can be mixed together. Especially, it is preferable for the present invention to use a lead-free deposition type solder composition.

In the present invention, the term "tin powder" indicates tin-silver base tin alloy powder containing silver, and tin-copper base tin alloy powder containing copper and the like, in addition to metallic tin powder.

Examples of the metal salt of the above (i) are organic carboxylate and organic sulfonate.

As the organic carboxylate, a mono- or dicarboxylic acid having a carbon number of 1 to 40 can be used. Examples of the organic carboxylic acid are lower fatty acids such as formic acid, acetic acid, and propionic acid; fatty acids obtainable from animal or vegetable oil and fats such as caproic acid, caprylic acid, lauric acid, myristic acid, palmitic acid, stearic acid, oleic acid, and linoleic acid; various kinds of synthetic acids obtainable from synthetic organic reactions such as 2,2-dimethylpentanoic acid, 2-ethylhexanoic acid, isononanoic acid, 2,2-dimethyloctanoic acid, and n-undecanoic acid; resin acids such as pimaric acid, abietic acid, dehydroabietic acid, and dihydroabietic acid; monocarboxylic acids such as naphthenic acid obtainable from petroleum; dimmer acid obtainable from synthesis of tall oil fatty acid and soybean fatty acid; and dicarboxylic acid such as polymer rosin obtainable from dimerization of rosin. Two or more kinds of these may be used.

Examples of the organic sulfonic acid are methane sulfonic acid, 2-hydoxyethanesulfonic acid, 2-hydroxy propane-1-sulfonic acid, trichloromethanesulfonic acid, trifluoromethanesulfonic acid, benzenesulfonic acid, toluenesulfonic acid, phenolsulfonic acid, cresolsulfonic acid, anisolesulfonic acid, and naphthalenesulfonic acid. Two or more kinds of these may be used.

The complex of the composition (ii) is a complex of silver ion and/or copper ion, and at least one selected from aryl phosphines, alkyl phosphines, and azoles.

As the above mentioned phosphines (aryl phosphines or alkyl phosphines), for example, a compound represented by the following general formula (1) is suitable. 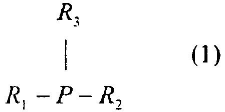 wherein R₁, R₂, and R₃ may be the same or different and each represents a substituted or a non-substituted aryl group, or a substituted or non-substituted chain or cyclic alkyl group having 1 to 8 carbon atoms. Here, the hydrogen atom of the aryl group may be substituted at any arbitrary position with an alkyl group or alkoxyl group having 1 to 8 carbon atoms, a hydroxyl group, an amino group, or a halogen atom. The hydrogen atom of the alkyl group may be substituted at any arbitrary position with an alkoxyl group having 1 to 8 carbon atoms, an aryl group, a hydroxyl group, an amino group, or a halogen atom.

Specifically, as phosphines, aryl phosphines such as triphenylphosphine, tri(o-, m-, or p-tolyl)phosphine, and tri(p- methoxyphenyl)phosphine; or alkyl phosphines such as tributyl phosphine, trioctyl phosphine, tris(3- hydroxypropyl)phosphine, and tribenzyl phosphine can be used suitably. Among others, triphenylphosphine, tri(p-tolyl)plaosphine, and tri(p- methoxyphenyl)phosphine, trioctyl phosphine, and tris(3-hydroxypropyl)phosphine can be used especially suitably, and triphenylphosphine, tri(p-tolyl)phosphine, or tri(p- methoxyphenyl)phosphine can be used most preferably.

The complex of aryl phosphines or alkyl phosphines is cationic, and hence a counter anion is necessary. As the counteranion, an organic sulfonic acid ion, an organic carboxylic acid ion, a halogen ion, a nitric acid ion, or a sulfuric acid ion is suitable. These can be used singularly or in combination of two or more kinds.

As the organic sulfonic acid used as the counteranion, for example, methanesulfonic acid, 2-hydroxyethanesulfonic acid, 2-hydroxypropane-1-sufonic acid, trichloromethane sulfonic acid, trifluoromethanesulfonic acid, benzenesulfonic acid, toluenesulfonic acid, phenolsulfonic acid, cresolsulfonic acid, anisolesulfonic acid, or naphthalenesulfonic acid can be used suitably. Among others, methanesulfonic acid, toluenesulfonic acid, or phenolsulfonic acid is especially preferred.

As the organic carboxylic acid used as the counteranion, for example, a monocarboxylic acid such as formic acid, acetic acid, propionic acid, butanoic acid, octanoic acid; a dicarboxylic acid such as oxalic acid, malonic acid, or succinic acid; a hydroxycarboxylic acid such as lactic acid, glycollic acid, tartaric acid, or citric acid; or a halogen-substituted carboxylic acid such as monochloroacetic acid, dichloroacetic acid, trichloroacetic acid, trifluoroacetic acid or perfluoropropionic acid can be used suitably. Among others, formic acid, acetic acid, oxalic acid, lactic acid, trichloroacetic acid, trifluoroacetic acid or perfluoropropionic acid is preferred, acetic acid, lactic acid or trifluoroacetic acid is most preferred.

As the above mentioned azoles, it is possible to use, for example, one type or a mixture of two or more kinds of tetrazole, triazole, benzotriazole, imidazole, benzimidazole, pyrazole, indazole, thiazole, benzothiazole, oxazole, benzoxazole, pyrrole, indole, or derivatives of these.

Among others, tetrazole, 5-mercapto-1-phenyltetrazole, 1,2,3-triazole, 1,2,4-triazole, 3-mercapto-1,2,4-triazole, benzotriazole, tolyltriazole, carboxybenzotriazole, imidazole, 2-mercaptoimidazole, benzimidazole, 2-octylbenzimidazole, 2-phenylbenzimidazole, 2-mercaptobenzimidazole, 2-methylthiobenzimidazole, pyrazole, indazole, thiazole, benzothiazole, 2-phenylbenzothiazole, 2-mercaptobenzothiazole; 2-methylthiobenzothiazole, isooxazole, anthranil, benzoxazole, 2-phenylbenzoxazole, 2-mercaptobenzoxazole, pyrrole, 4,5,6,7-tetrahydroindole; or indole is preferred.

Especially preferred are 5-mercapto-1-phenyltetrazole, 3-mercapto-1.2,4-triazole, benzotriazole, tolyltriazole, carboxybenzotriazole, imidazole, benzimidazole, 2-octylbenzimidazole, 2-mercaptobenzimidazole, benzothiazole, 2-mercaptobenzothiazole, benzoxazole, and 2-mercaptobenzoxazole.

The ratio of the tin powder to the salt of the metal or the complex in the above mentioned deposition type solder composition (the ratio of the mass of tin powder to the mass of the salt of metal or the complex) is approximately 99:1 to approximately 50:50; preferably approximately 97:3 to approximately 60:40.

Preferably, the solder paste composition of the present invention contains a flux in addition to the above mentioned components. The flux comprises mainly a base resin, an active agent (activator) and a thixotropy agent. When the flux is used in its liquid state, an organic solvent may be added thereto.

As the base resin, for example, rosin or acryl resin can be used.

As the rosin, rosin conventionally used for the purpose of a flux, or its derivative can be used. As the rosin, for example, usual gum rosin, tall rosin, and wood rosin can be used. As a rosin derivative, for example, heat-treated resin, polymer rosin, hydrogenated rosin, formylated rosin, rosin ester, rosin modified maleic resin, rosin modified phenol resin, and rosin modified alkyd resin can be used.

Preferably, the acryl resin has a molecular weight of 10,000 or below, more preferably 3,000 to 8,000. When the molecular weight exceeds 10,000, crack resistance and stripping resistance might be lowered. In order to aid active action, it is preferable to use a resin having an acid number of 30 or more. Since it is necessary for the resin to be softened during the time of soldering, the softening point is preferably 230°C or below. Hence, it is preferable that the acryl resin is obtained as follows; a monomer having a polymerizable unsaturated group, such as acrylic (methacrylic) acid or its various esters, crotonic acid, itaconic acid, maleic acid (anhydride) or its ester, acrylonitrile (methacrylonitrile), acrylamide (methacrylamide), vinyl chloride, or vinyl acetate, is used and radical polymerized by a block polymerization method, liquid polymerization method, suspension polymerization method, emulsion polymerization method or the like, by using a catalyst such as a peroxide.

The above mentioned base resins can be used together. For example, the rosin and the acrylic resin may be used in mixtures with each other. The content of the base resin is 0.5 to 80 mass %, preferably 20 to 70 mass %, to the total amount of the flux.

Examples of the active agent are hydrohalogenic acid salts such as ethylamine, propylamine, diethylamine, triethylamine, ethylenediamine, and aniline; and organic carboxylic acids such as lactic acid, citric acid, stearic acid, adipic acid, diphenylacetic acid, and benzoic acid. The content of the active agent is preferably 0.1 to 30 mass % to the total amount of the flux.

Examples of the thixotropy agent are cured castor oil, beeswax, and carnauba wax. The content of the thixotropy agent is preferably 1 to 50 mass % to the total amount of the flux.

Examples of the organic solvent are alcohol based solvents such as ethyl alcohol, isopropyl alcohol, ethyl cellosolve, butyl carbitol, and hexyl carbitol; ester based solvents such as ethyl acetate and butyl acetate; and hydrocarbon based solvents such as toluene and turpentine oil. From the viewpoints of the volatility and the solubility of the active agent, it is preferable to use the alcohol based solvent as the main solvent. Preferably, the organic solvent is added in a range of 1 to 99 mass % to the total amount of the flux.

The flux used in the present invention can be used together with a synthetic resin well-known as base resin for the flux, such as a polyester resin, phenoxy resin, or terpene resin. Alternatively, additives such as an oxidation inhibitor, a fungicide, and a flatting agent may be added to the flux. The above mentioned salt of metal or the complex may be incorporated in the flux.

The mass ratio of the above mentioned solder powder to the flux in the solder paste composition of the present invention (the ratio of the solder powder to the flux) is preferably approximately 95:5 to approximately 80:20.

No special limitations are imposed on the method of filling the above mentioned solder paste composition 5 onto the electrodes 2 within the opening parts surrounded by the dam 4. For example, imprinting may be used for the filling. No special limitations are imposed on the heating temperature when the solder is adhered to the surfaces of the electrodes 2 by heating it to a predetermined temperature after the filling. However, in consideration of the heat resistance of the electronic components, the heating temperature is about 180 to 280°C, preferably about 200 to 250°C. The heating time may be determined suitably according to the constitution of the composition, or the like, and it is usually about 30 seconds to 10 minutes, preferably about 1 minute to 5 minutes.

The height of the solder bumps 6 obtained is usually approximately 40 to 100 µm. In accordance with the present invention, the solder bumps 6 can be arranged with a fine pitch, for example, with a pitch of approximately 50 to 120 µm.

Examples of the present invention will be described below in detail. It is understood, however, that the examples are for the purpose of illustration and the invention is not to be regarded as limited to any of the specific materials or condition therein.

### EXAMPLES

It will be understood that where examples fall outside of the claimed subject matter, these are provided for information purposes only.

### [Examples 1 to 4 and Comparative Examples 1 to 4]

### <Manufacture of Dam>

A substrate was used, a surface of which was coated with a solder resist film having a thickness of 15 µm, pads (electroless nickel metal plating electrodes) being exposed from opening parts (85 µm in diameter) formed in the solder resist film. Specifically, 841 pads were formed on the substrate with a pitch of 225 µm.

A dry film resist (Product name "SUNFORT™ AQ4036" manufactured by Asahi Kasei EMD Corporation) was press-adhered to the surface of the substrate. Then, a mask was disposed on the surface of a photosensitive resin layer, and the respective pads and their surroundings were exposed, and thereafter a support film was stripped, followed by development with an aqueous solution of Na₂CO₃. Thus, a (resist) dam, opening parts of which had an inner diameter of 150 µm and a thickness of 40 µm, was formed with a pitch of 225 µm around the pads.

### <Manufacture of Solder Paste Compositions>

Each of Sn/Cu alloy powders (alloy powders Nos. 01 to 08) having a particle size distribution shown in the following Table 1, and a flux were kneaded at the following rate, thereby obtaining solder paste compositions as shown in Table 2 (solder pastes Nos. 01P to 08P).

| | |
|---|---|
| Sn/Cu alloy powder | 88 mass % |
| (Sn/Cu (mass ratio)=99.3/0.7) | |
| Flux | 12 mass % |

The flux used above was manufactured by mixing the following ingredients and heat-melting at 150°C, followed by cooling to room temperature.

| | |
|---|---|
| Rosin resin | 50 mass % |

### (formylated rosin, product name "FG-90"manufactured by Harima Chemicals, Inc.)

| | |
|---|---|
| Benzoic acid (organic acid) | 8 mass % |
| Hexyl carbitol (solvent) | 7 mass % |
| Cured castor oil (thixotropy agent) | 35 mass % |

**Table 1**

| Alloy powders¹⁾ No. | Particle size distribution (%) ²⁾ | | | |
|---|---|---|---|---|
| | below 10µm | 10µm or more below 20µm | 20µm or more | below 10µm + 10µm or more below 20µm |
| 01 | 20 | 79 | 1 | 99 |
| 02 | 90 | 9 | 1 | 99 |
| 03 | 52 | 38 | 10 | 90 |
| 04 | 16 | 74 | 10 | 90 |
| 05 | 8 | 78 | 14 | 86 |
| 06 | 1 | 90 | 9 | 91 |
| 07 | 38 | 50 | 12 | 88 |
| 08 | 32 | 56 | 12 | 88 |

| | | | | |
|---|---|---|---|---|
| 1.) Sn/Cu (mass ratio) = 99.3/0.7 2) Particle size distribution was measured by using a microtrack particle size distribution analyzer (product name "MT3000" manufactured by Nikkiso Co., Ltd.). | | | | |

### <Solder Precoating Process>

Each of the solder paste compositions obtained above (the solder pastes Nos. 01P to 08P) was filled by imprinting into individual opening parts of the above mentioned substrate provided with the dam. Subsequently, under an atmosphere of nitrogen, the solder was melted by heating to 230°C or above for one minute, and solder precoating was carried out to form solder bumps.

### <Dam Removing Process>

A 17 ml of 2-ethanolamine (manufactured by MITSUBISHI GAS CHEMICAL COMPANY, INC.) was mixed with 83 ml of distilled water at room temperature, thereby obtaining 100 ml of a stripping agent. The 100 ml of the stripping agent was then poured into a 200ml beaker, and heated to about 50°C on a hot plate. Thereafter, the dam was removed by immersing the above mentioned substrate subjected to the solder precoating process in the stripping agent for two minutes.

### <Cleaning of Solder Paste Residue>

A 300 ml of butyl carbitol solution was poured into a 500ml-beaker, and the above mentioned substrate with the dam removed was immersed in this solution of 80°C for two minutes, while applying ultrasonic thereto. Subsequently, this substrate was immersed in 300 ml of isopropyl alcohol for two minutes, in order to remove excess solder paste composition. Thereafter, by hot air, each of the substrates was dried to manufacture a solder precoated substrate with a pitch of 225 µm. Five solder precoated substrates were manufactured per solder paste (The precoating process was carried out under the same heating condition.).

The respective solder precoated substrates thus obtained were evaluated in terms of solder bump defects. The evaluation method is as follows, and the results are presented in Table 2.

### <Evaluation Method of Solder Bump Defects>

In respect to the individual solder precoated substrates after the solder paste residue cleaning, the presence or absence of solder bump defect locations in the five substrates was checked on a microscope ("VHX-200" manufactured by KEYENCE CORPORATION), to determine the number of occurrence of the defects.

**Table 2**

| | Solder paste No. | Alloy powder No. | Number of solder bump defects¹⁾ | | | | |
|---|---|---|---|---|---|---|---|
| | | | Substrate 1 | Substrate 2 | Substrate 3 | Substrate 4 | Substrate 5 |
| Example 1 | 01P | 01 | 0 | 0 | 0 | 0 | 0 |
| Example 2 | 02P | 02 | 0 | 0 | 0 | 0 | 0 |
| Example 3 | 03P | 03 | 0 | 0 | 0 | 0 | 0 |
| Example 4 | 04P | 04 | 0 | 0 | 0 | 0 | 0 |
| Comparative Example 1 | 05P | 05 | 2 | 1 | 1 | 0 | 2 |
| Comparative Example 2 | 06P | 06 | 35 | 20 | 28 | 31 | 22 |
| Compararive Example 3 | 07P | 07 | 18 | 0 | 2 | 0 | 4 |
| Comparative Example 4 | 08P | 08 | 5 | 12 | 0 | 2 | 0 |

| | | | | | | | |
|---|---|---|---|---|---|---|---|
| 1) The number of pads to be measured is 841 per substrate (all of the pads were measured). | | | | | | | |

It will be noted from Table 2 that the solder bumps formed by using the solder paste compositions of Examples 1 to 4 (the solder pastes Nos. 01P to 04P) suppressed the occurrence of bump defects and improved the yield. In contrast, the solder bumps formed by using the solder paste compositions of Comparative Examples 1 to 4 (the solder pastes Nos. 05P to 08P) had bump defects.

### [Examples 5 to 7 and Comparative Example 5]

### <Manufacture of Dam>

A substrate was used, a surface of which was coated with a solder resist film having a thickness of 10 µm, pads (electroless nickel metal plating electrodes) being exposed from opening parts (70 µm in diameter) formed in the solder resist film. Specifically, 6,561 pads were formed on the substrate with a pitch of 150 µm.

Subsequently, in the same manner as in Examples 1 to 4, a (resist) dam, opening parts of which had an inner diameter of 150 µm and a thickness of 40 µm, was formed with a pitch of 150 µm around the pads.

### <Manufacture of Solder Precoated Substrates>

The solder paste compositions (solder pastes Nos. 01P, 03P, 04P, and 06P), which were obtained in Examples 1, 3, and 4, and Comparative Example 2, respectively, were used.

In the same manner as in Examples 1 to 4, the solder precoating process, the dam removing process, and the solder paste residue cleaning were carried out to obtain each solder precoated substrate with a pitch of 150 µm. Two solder precoated substrates were manufactured per solder paste (The precoating process was carried out under the same heating condition.).

In respect to the individual solder precoated substrates, the evaluation of solder bump defects was conducted in the same manner as in Examples 1 to 4. The results are presented in Table 3.

**Table 3**

| | Solder Paste No. | Alloy powder No. | Number of solder bump deflects¹⁾ | |
|---|---|---|---|---|
| | | | Substrate 1 | Substrate 2 |
| Example 5 | 01P | 01 | 0 | 0 |
| Example 6 | 03P | 03 | 0 | 0 |
| Example 7 | 04P | 04 | 3 | 0 |
| Comparative Example 5 | 06P | 06 | 8 | 6 |

| | | | | |
|---|---|---|---|---|
| 1) The number of pads to be measured is 6,561 per substrate (All of the pads were measured.). | | | | |

It will be noted from Table 3 that the solder bumps formed by using the solder paste compositions of Examples 5 to 7 (the solder pastes Nos. 01P, 03P, and 04P) had fewer bump defects and suppressed the occurrence of the bump defects. In contrast, the solder bump formed by using the solder paste composition of Comparative Example 5 (the solder paste No. 06P) had a large number of bump defects.

Next, in respect to the above individual solder precoated substrates with a pitch of 150 µm the heights of the solder bumps were measured to evaluate the average height and variations in height (standard deviation). The evaluation method is as follows, and the results are presented in Table 4.

### <Methods of Evaluating Average Height of Solder Bumps and Variations in Height>

- Using a depth of focus meter (product name "STM" manufactured by OLYMPUS CORPORATION), the distance from the solder resist surface to the bump top was measured as a solder height. The solder heights of arbitrary 60 bumps per substrate were determined, and the average value (the average height of the solder bumps) and variations in height (standard deviation) were calculated from the results of the measurements.

**Table 4**

| | Solder Paste No. | Alloy Powder No. | Average Height of Solder Bumps (AVG) (µm) | Standard deviation STD |
|---|---|---|---|---|
| Example 5 | 01P | 01 | 45.5 | 2.5 |
| Example 6 | 03P | 03 | 47.4 | 2.2 |
| Example 7 | 04P | 04 | 46.0 | 3.1 |
| Comparative Example 5 | 06P | 06 | 45.1 | 5.2 |

It will be noted from Table 4 that the solder bumps formed by using the solder paste compositions of Examples 5 to 7 (the solder pastes Nos. 01P, 03P, and 04P) produced solder bumps of a uniform heights. In contrast, the solder bumps formed by using the solder paste compositions of Comparative Example 5 (the solder paste No. 06P) had variations in height.

### [Examples 8 to 10 and Comparative Example 6]

### <Manufacture of Dam>

The same substrates as in Examples 5 to 7 were used. Subsequently, in the same manner as in Examples 5 to 7 were used subsequently, a (resist) dam, opening parts of which had an inner diameter of 150 µm and a thickness of 40 µm, was formed on the surface of each of the substrates with a pitch of 150 µm around the pads.

### <Manufacture of Solder Paste Compositions>

Each of solder paste compositions as shown in Table 5 (solder pastes Nos. 09P to 12P, each being deposition type solder composition) were obtained in the same manner as in Examples 1 to 4, except that Sn/Cu alloy powders (alloy powders Nos. 01, 03, 04, and 06) having a particle size distribution shown in Table 1, and the following flux were used.

The flux used was obtained by mixing the following ingredients and heat-melting at 150°C, followed by cooling to room temperature.

| | |
|---|---|
| Rosin resin | 40 mass % |
| (formylated rosin, product name "FG-90" manufactured by Harima Chemicals, Inc.) | |
| Benzoic acid (organic acid) | 8 mass % |
| Hexyl carbitol (solvent) | 7 mass % |
| Cured castor oil (thixotropy agent) | 35 mass % |
| Copper stearate | 10 mass % |

### <Manufacture of Solder Precoated Substrates>

In the same manner as in Examples 1 to 4, the solder precoating process, the dam removing process, and the solder paste residue cleaning were carried out to obtain each solder precoated substrate with a pitch of 150 µm. Two solder precoated substrates were manufactured per solder paste (The precoating process was carried out under the same heating condition.).

In respect to the individual solder precoated substrates, the evaluation of solder bump defects was conducted in the same manner as in Examples 1 to 4. The results are presented in Table 5.

**Table 5**

| | Solder paste No. | Alloy powder No. | Number of solder bump defects¹⁾ | |
|---|---|---|---|---|
| | | | Substrate 1 | Substrate 2 |
| Example 8 | 09P | 01 | 0 | 0 |
| Example 9 | 10P | 03 | 0 | 0 |
| Example 10 | 11P | 04 | 1 | 1 |
| Comparative Example 6 | 12P | 06 | 9 | 4 |

| | | | | |
|---|---|---|---|---|
| 1) The number of pads to be measured is 6,561 per substrate (all of the pads were measured). | | | | |

It will be noted from Table 5 that the solder bumps formed by using the solder paste compositions of Examples 8 to 10 (the solder pastes Nos. 09P to 11P) had fewer bump defects and suppressed the occurrence of the bump defects. In contrast, the solder bump formed by using the solder paste composition of Comparative Example 6 (the solder paste No. 12P) had a large number of bump defects.

While one preferred embodiment of the present invention has been described, the present invention is not limited to the foregoing embodiment.

## Claims

1. A solder paste composition for use in a solder precoating method of forming solder bumps by forming a dam around electrodes on a substrate,
wherein the solder paste composition contains solder powder which is of a particle size distribution in which particles having a particle size of below 10 µm are present 16% or more, and the sum of the particles having a particle size of below 10 µm and particles having a particle size of 10 µm or more and below 20 µm is 90% or more, the solder paste composition being of a deposition type.

2. A solder paste composition according to claim 1, wherein the solder powder is of a particle size distribution in which particles having a particle size of below 10 µm are present 20% or more.

3. A solder paste composition according to claim 1 or 2, wherein the solder powder is of a particle size distribution in which the sum of particles having a particle size of below 10 µm and particles having a particle size of 10 µm or more and below 20 µm is 95% or more.

4. A solder paste composition according to any of Claims 1 to 3, containing tin powder and a salt of a metal selected from lead, copper and silver.

5. A solder paste composition according to any of Claims 1 to 3, containing tin powder and a complex of at least one ion selected from silver ions and copper ions and at least one compound selected from aryl phosphines, alkyl phosphines, and azoles.

6. A solder paste composition according to claim 4 or 5, wherein the ratio of the mass of the tin powder to the mass of the metal salt or the complex is from 99:1 to 50:50.

7. A solder precoating method of forming solder bumps by forming a dam around electrodes on a substrate, introducing a solder paste composition over the electrodes within openings surrounded by the dam, and heating the solder paste composition introduced, so that solder adheres to surfaces of the electrodes, wherein the method uses a solder paste composition according to any of claims 1 to 6.

## Patentansprüche

1. Lötpastenzusammensetzung zur Verwendung in einem Verfahren zur Lötvorbeschichtung zur Bildung von Lötkontakthügeln durch Bildung eines Damms um Elektroden auf einem Substrat,
wobei die Lötpastenzusammensetzung Lötpulver enthält, welches von einer Teilchengrößenverteilung ist, in welcher Teilchen mit einer Teilchengröße unterhalb von 10 µm zu 16 % oder mehr vorliegen und die Summe der Teilchen mit Teilchengröße unterhalb von 10 µm und von Teilchen mit Teilchengröße von 10 µm und mehr und unterhalb von 20 µm bei 90 % oder mehr liegt, wobei die Lötpastenzusammensetzung von einem Auftragungstypus ist.

2. Lötpastenzusammensetzung nach Anspruch 1, wobei das Lötpulver eine Teilchengrößenverteilung hat, in welcher Teilchen mit einer Teilchengröße unterhalb von 10 µm zu 20 % und mehr vorliegen.

3. Lötpastenzusammensetzung nach Anspruch 1 oder 2, wobei das Lötpulver eine Teilchengrößenverteilung hat, in welcher die Summe von Teilchen mit einer Teilchengröße unterhalb von 10 µm und Teilchen mit einer Teilchengröße von 10 µm und mehr und unterhalb von 20 µm bei 95 % oder mehr liegt.

4. Lötpastenzusammensetzung nach einem der Ansprüche 1 bis 3, enthaltend Zinnpulver und ein Salz eines Metalls ausgewählt aus Blei, Kupfer und Silber.

5. Lötpastenzusammensetzung nach einem der Ansprüche 1 bis 3, enthaltend Zinnpulver und ein Komplex von mindestens einem Ion ausgewählt aus Silberionen und Kupferionen und mindestens einer Verbindung ausgewählt aus Arylphosphanen, Alkylphosphanen und Azolen.

6. Lötpastenzusammensetzung nach Anspruch 4 oder 5, wobei das Verhältnis der Menge des Zinnpulvers zu der Menge des Metallsalzes oder des Komplexes zwischen 99:1 bis 50:50 liegt.

7. Verfahren zur Lötvorbeschichtung zur Bildung von Lötkontakthügeln durch Bildung eines Damms um Elektroden auf einem Substrat, einbringend eine Lötpastenzusammensetzung über die Elektroden innerhalb von Öffnungen umgeben von dem Damm und Erhitzen der eingebrachten Lötpastenzusammensetzung derart, dass das Lötmittel an die Oberflächen der Elektroden anhaftet, wobei das Verfahren eine Lötpastenzusammensetzung nach einem der Ansprüche 1 bis 6 verwendet.

## Revendications

1. Composition de pâte à braser pour son utilisation dans un procédé de revêtement préalable de brasure pour former des perles de brasure par la formation d'une barrière autour d'électrodes sur un substrat,
dans laquelle la composition de pâte à braser contient une poudre de brasure présentant une répartition de tailles de particule dans laquelle les particules ayant une taille de particule inférieure à 10 µm représentent 16 % ou plus, et la somme des particules ayant une taille de particule inférieure à 10 µm et des particules ayant une taille de particule de 10 µm ou plus et inférieure à 20 µm est de 90 % ou plus, la composition de pâte à braser étant d'un type pour dépôt.

2. Composition de pâte à braser selon la revendication 1, dans laquelle la poudre de brasure présente une répartition de tailles de particule dans laquelle les particules ayant une taille de particule inférieure à 10 µm représentent 20 % ou plus.

3. Composition de pâte à braser selon la revendication 1 ou 2, dans laquelle la poudre de brasure présente une répartition de tailles de particule dans laquelle la somme des particules ayant une taille de particule inférieure à 10 µm et des particules ayant une taille de particule de 10 µm ou plus et inférieure à 20 µm est de 95 % ou plus.

4. Composition de pâte à braser selon l'une quelconque des revendications 1 à 3, contenant une poudre d'étain et un sel d'un métal choisi parmi le plomb, le cuivre et l'argent.

5. Composition de pâte à braser selon l'une quelconque des revendications 1 à 3, contenant une poudre d'étain et un complexe d'au moins un ion choisi parmi les ions d'argent et les ions de cuivre et d'au moins un composé choisi parmi les aryl-phosphines, les alkylphosphines et les azoles.

6. Composition de pâte à braser selon la revendication 4 ou 5, dans laquelle le rapport masse de la poudre d'étain sur masse du sel métallique ou du complexe est de 99/1 à 50/50.

7. Procédé de revêtement préalable de brasure pour former des perles de brasure par la formation d'une barrière autour d'électrodes sur un substrat, l'introduction d'une composition de pâte à braser sur les électrodes au sein d'ouvertures entourées par la barrière et le chauffage de la composition de pâte à braser introduite, de façon que la brasure adhère aux surfaces des électrodes, dans lequel le procédé fait appel à une composition de pâte à braser selon l'une quelconque des revendications 1 à 6.
